Europäisches Patentamt

European Patent Office

Office européen des brevets

(11) Veröffentlichungsnummer: **0 309 648**

**A1**

## EUROPÄISCHE PATENTANMELDUNG

(21) Anmeldenummer: 88108380.2

(22) Anmeldetag: 26.05.88

(51) Int. Cl.⁴: **H01J 37/32 , C23C 16/50 , C23F 4/00**

(30) Priorität: 01.10.87 DE 3733135

(43) Veröffentlichungstag der Anmeldung:
05.04.89 Patentblatt 89/14

(84) Benannte Vertragsstaaten:
CH DE FR GB IT LI NL

(71) Anmelder: **LEYBOLD AKTIENGESELLSCHAFT**
**Wilhelm-Rohn-Strasse 25**
**D-6450 Hanau 1(DE)**

(72) Erfinder: **Grünwald, Heinrich, Dr.**
**Taunusstrasse 61**
**D-6450 Hanau 9(DE)**

(74) Vertreter: **Schickedanz, Willi, Dipl.-Ing.**
**Langener Strasse 68**
**D-6050 Offenbach/Main(DE)**

(54) **Vorrichtung zum Beschichten oder Ätzen mittels eines Plasmas.**

(57) Die Erfindung betrifft eine Vorrichtung zum Beschichten oder Ätzen mittels eines Plasmas. Hierbei ist eine erste Elektrode (5) an eine Hochfrequenzspannung gelegt, welche das Plasma aus einem Gas erzeugt. Eine zweite Elektrode (6), auf der sich das zu beschichtende oder ätzende Substrat (7) befindet, ist mit einer Mittelfrequenzspannung verbunden, welche die Ionen des Plasmas auf das Substrat (7) beschleunigt. Diese Mittelfrequenzspannung besteht erfindungsgemäß aus unipolaren Impulsen, die für eine vorgebbare Zeit alle die gleiche Amplitude besitzen. Die Anzahl der Ionen, die auf das Substrat (7) auftreffen, ist hierdurch von der Amplitude der anliegenden Mittelfrequenzspannung entkoppelt. Sie wird nur durch die Häufigkeit bzw. Breite dieser Impulse bestimmt.

## VORRICHTUNG ZUM BESCHICHTEN ODER ÄTZEN MITTELS EINES PLASMAS

Die Erfindung betrifft eine Vorrichtung zum Beschichten oder Ätzen mittels eines Plasmas, mit einer ersten Elektrode, die mit dem zu ätzenden oder zu beschichtenden Substrat in elektrischer Verbindung steht, sowie mit einer zweiten Elektrode, die oberhalb der ersten Elektrode angeordnet ist, wobei sich beide Elektroden innerhalb einer Prozeßkammer befinden, die als dritte Elektrode dient, und wobei die erste Elektrode mit einem Mittelfrequenzgenerator verbunden ist, der den Strom und die Energie des Ionenbombardements auf das Substrat steuert, während die zweite Elektrode mit einem Hochfrequenzgenerator verbunden ist, der den Betrag der Dissoziation und die Bildung der Radikale steuert.

Für das Beschichten oder Ätzen von Substraten werden außer Naßverfahren im verstärkten Maß auch Trockenverfahren eingesetzt. Während bei den Naßverfahren eine flüssige und ätzende bzw. eine ablagernde Substanz auf bestimmte Stellen eines Substrats aufgetragen wird, werden bei den Trockenverfahren Gase verwendet, die als Ionen Teile aus den Substraten herausschlagen oder sich unter Bildung von chemischen Verbindungen an diese Substrate anlagern. Die Vorteile der Trockenverfahren bestehen in den niedrigeren Kosten für Chemikalien, in einer geringeren Umweltbelastung und in einem hohen Automatisierungsgrad.

Es sind bereits zahlreiche Trockenverfahren bekannt, denen die Verwendung eine Gasplasmas gemeinsam ist und die sich hauptsächlich durch verschiedene Gase, Gasdrücke und Elektrodenanordnungen unterscheiden (S. J. Fonash: Advances in Dry Etching Processes - A Review, Solid State Technology, Januar 1985, S. 150 bis 158). Unter diesen Verfahren spielt das sogenannte Triodenverfahren in der Praxis eine immer größer werdende Rolle.

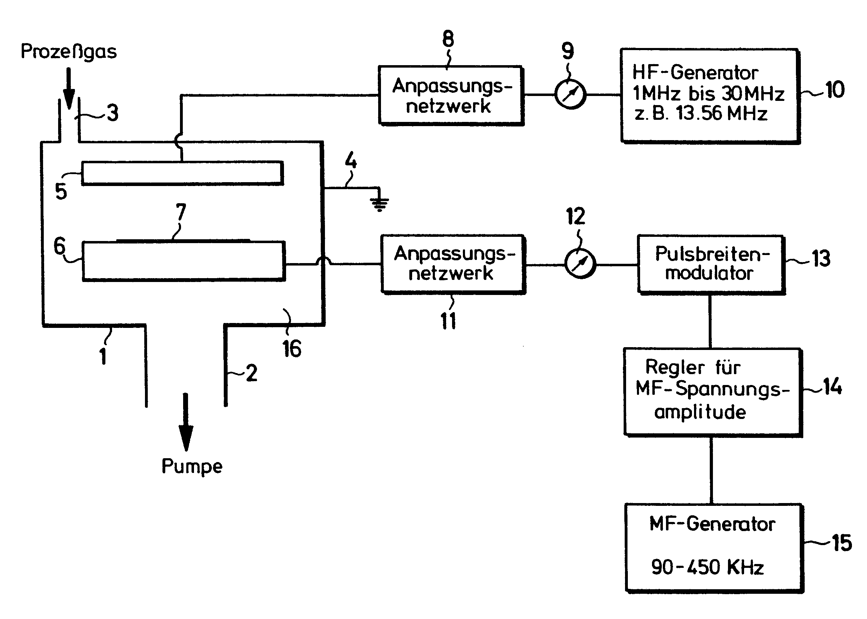

Bei dem Triodenverfahren werden gesonderte Hochfrequenzspannungen an eine Substratelektrode - meist die untere Elektrode - und an eine weitere Elektrode in einem Reaktor angelegt (Fonash, a.a.O., S. 152, Fig. 2; Tegal Process Review, Mai 1984, Vol. 1, Nr. 1). Die dritte Elektrode wird durch ein zumeist geerdetes Gehäuse gebildet, das die beiden anderen Elektroden umgibt. Die Hochfrequenzspannung an der einen Elektrode wird beispielsweise auf 13,56 MHz gelegt, so daß das Gas hierdurch ionisiert wird. Bei dieser hohen Frequenz können jedoch die Ionen wegen ihrer Trägheit nicht zum Substrat gelangen. Besondere Bedeutung kommt deshalb der Spannung an der Substratelektrode zu. Wird ihre Frequenz deutlich unter 1 MHz gewählt, so können die Ionen des Plasmas von dieser Spannung durch den Dunkelraum über die Substratelektrode hindurch auf das Substrat beschleunigt werden. Entscheidend für die kinetische Energie dieser Ionen ist in diesem Fall einerseits die Potentialdifferenz zwischen dem Volumen des Plasmas, d.h. einem Punkt der Raumladung, und der Substratelektrode und andererseits die Ausgangsspitzenspannung der Hochfrequenz- bzw. Mittelfrequenzspannung an der Substratelektrode. Bei der erwähnten Potentialdifferenz handelt es sich um eine Gleichspannung, die sich gewissermaßen automatisch aufgrund der vorhandenen Raumladungsverhältnisse ausbildet. Die Mittelfrequenzspannung, die an der Substratelektrode liegt, ist dagegen einstellbar und kann somit den Ionenstrom steuern.

Ein Nachteil der bisher bekannten Triodenanordnungen besteht darin, daß aufgrund der verwendeten Generatoren die Ausgangsspitzenspannung nicht unabhängig von der Leistung eingestellt werden kann. Dies bedeutet, daß jedesmal dann, wenn die Ausgangsspitzenspannung geändert wird, auch der Ionenstrom automatisch mitverändert wird. In vielen Fällen ist dies jedoch unerwünscht, weil bei hohen Spannungen eine Schädigung des Substrats eintreten kann.

Der Erfindung liegt deshalb die Aufgabe zugrunde, die Potentialdifferenz zwischen dem Volumen des Plasmas und den Substraten weitgehend unabhängig von der eingespeisten elektrischen Leistung zu steuern.

Diese Aufgabe wird dadurch gelöst, daß der Strom des Ionenbombardements auch bei einer fest vorgegebenen Spannung des Mittelfrequenzgenerators steuerbar ist.

Der mit der Erfindung erzielte Vorteil besteht insbesondere darin, daß die für den Anregungs-, Fragmentierungs- und Ionisationsgrad des Plasmas maßgebliche eingespeiste elektrische Leistung und die für die Energie der auf das Substrat auftreffenden Ionen relevante Mittelfrequenzspannung voneinander unabhängig auf ihre jeweiligen Optimalwerte eingestellt werden können. Dadurch, daß eine von der Substratelektrode verschiedene Elektrode mit einer Hochfrequenzspannung von vorzugsweise 13,56 MHz gespeist wird, während die Substratelektrode mit einer Hochfrequenzspannung von vorzugsweise 90 bis 450 KHz gespeist wird, die keine positiven Anteile enthält und stufenlos von 20 V bis 200 V geregelt werden kann, ist es möglich, die vom Mittelfrequenzgenerator eingespeiste elektrische Leistung zu regeln, ohne daß die Höhe der Mittelfrequenzspannung, d. h. die Ausgangsspitzenspannung verändert wird. Die Beschleunigung, welche die Ionen erhalten, ist somit innerhalb eines vorgegebenen Zeitabschnitts immer gleich. Die Anzahl der auf das Substrat auftreffenden Ionen kann jedoch trotzdem geregelt werden, indem die Mittelfrequenzspannung intermittierend an die Substratelektrode gelegt wird. Hierdurch werden die Ionen gewissermaßen in Paketen oder Bündeln auf das Substrat beschleunigt. die Ausgangsspitzenspannung der Mittelfrequenzspannung kann auf diese Weise niedrig gehalten werden, so daß keine Substratschädigungen auftreten.

Ein Ausführungsbeispiel der Erfindung ist in der Zeichnung dargestellt und wird im folgenden näher beschrieben.

Die einzige Figur zeigt eine Prinzipanordnung der Erfindung.

Hierbei ist eine Prozeßkammer 1 vorgesehen, die einen Gasauslaßstutzen 2 und einen Gaseinlaßstutzen 3 aufweist. Die Prozeßkammer 1 besteht aus einem metallischen Gehäuse, das über eine Leitung 4 an Erdpotential gelegt ist. In der Prozeßkammer 1 selbst befindet sich eine obere Elektrode 5, der eine untere Elektrode 6 gegenüberliegt. Mit dieser unteren Elektrode 6 elektrisch verbunden ist ein Substrat 7, das zu ätzen oder zu beschichten ist. Die obere Elektrode 5 ist über ein Anpassungsnetzwerk 8 und ein Leistungsmeßgerät 9 mit einem Hochfrequenzgenerator 10 verbunden, dessen Frequenz z. B. zwischen 1 MHz und 30 MHz frei gewählt werden kann. Mit der Spannung des Hochfrequenzgenerators wird das zunächst neutrale Gas in Ionen und Elektronen aufgespalten. Die untere Elektrode 6 ist über ein Anpassungsnetzwerk 11 und ein Leistungsmeßgerät 12 mit einem Pulsbreitenmodulator 13 verbunden, der von einem Regler 14 für die Hochfrequenzspannungsamplitude gesteuert wird. Dieser Regler 14 ist seinerseits mit einem Mittelfrequenzgenerator 15 verbunden, der vorzugsweise mit einer Frequenz von 90 bis 450 KHz betrieben wird.

Im folgenden wird die Funktionsweise der Anordnung gemäß der Figur beschrieben. Zunächst wird die Prozeßkammer 1 mit 'Hilfe eines nicht dargestellten Pumpensatzes, der mit dem Gasauslaßstutzen 2 verbunden ist, auf einen Basisdruck von $10^{-4}$ Pa evakuiert. Anschließend wird ein Prozeßgas oder Prozeßgasgemisch 16, das beispielsweise aus SF6 und C1₂ besteht, in einem Mischungsverhältnis von 1:1 und mit einer vorbestimmten Durchflußrate von beispielsweise 100 cm³/bar . min durch den Gaseinlaß 3 dem Innenraum der Prozeßkammer 1 kontinuierlich zugeführt. Durch eine geeignete Regelung der Saugleistung des Pumpensatzes wird ein vorbestimmter Druck von beispielsweise 15 Pa eingestellt. Jetzt wird die Spannung des Hochfrequenzgenerators 10 auf 13,56 MHz und auf eine Leistung von 400 W eingestellt und über das Leistungsmeßgerät 9 und die Anpassungsschaltung 8 auf die obere Elektrode 5 gegeben. Gleichzeitig wird mit Hilfe des Mittelfrequenzgenerators 15 eine Mittelfrequenzspannung von 150 KHz erzeugt. Die Amplitude dieser Mittelfrequenzspannung wird durch den Regler 14 auf einen vorbestimmten Wert von etwa 30 Volt eingestellt, während die Leistung des Mittelfrequenzgenerators 15 mit Hilfe des Pulsbreitenmodulators 13 auf 100 W eingestellt wird. Hierdurch wird zwischen der unteren Elektrode 6 und der oberen Elektrode 5 ein Plasma erzeugt, unter dessen Einfluß eine obere dünne Schicht des Substrats 7 mit hoher Rate durchgeätzt wird, ohne daß das Substrat 7 selbst in nennenswerter Weise angegriffen wird. Bei der oberen dünnen Schicht handelt es sich vorzugsweise um eine Polysiliziumschicht, während sich die darunter liegende Schicht ihrerseits wieder in mehrere Schichten gliedert. Die unterste Schicht ist das eigentliche Substrat aus Silizium, auf der sich eine Schicht von 0,1 µm Dicke aus thermischem SiO₂ befindet. Hierüber befindet sich eine 0,4 µm dicke Schicht aus Polysilizium, die von einer 1 µm dicken Photolack-Schicht überdeckt ist. Die Durchätzung der oberen Polysiliziumschicht erfolgt auf anisotrope Weise, und zwar mit einer Durchätzungsrate von 1 µm/min.

Dadurch, daß die Mittelfrequenzspannung in Form von unipolaren Impulsen auf die Substratelektrode 6 gegeben wird, die innerhalb eines vorgebbaren Zeitraums stets die gleiche Amplitude besitzen, werden die Ionen alle gleich beschleunigt, d.h. sie treffen mit derselben Geschwindigkeit auf das Substrat auf. Die Zahl der auftreffenden Ionen kann dennoch variiert werden, indem die Impulse einmal mehr oder weniger lang angelegt werden. Das Ausführungsbeispiel wurde zwar anhand der Pulsbreitenmodulation beschrieben, doch sind auch alle anderen Modulationsarten, die innerhalb eines vorgebbaren Zeitraums eine konstante Amplitude aller Impulse gewährleisten, für die Realisierung der Erfindung geeignet.

Selbstverständlich ist es mit der Erfindung auch möglich, die Amplitude der Impulse zu variieren, sofern dies gewünscht wird. Damit sind mit der Erfindung dieselben Möglichkeiten wie bei den herkömmlichen Verfahren gegeben, wobei zusätzlich eine Entkopplung von anliegender Spannung und Ionenstrom realisierbar ist.

## Ansprüche

1. Vorrichtung zum Beschichten oder Ätzen mittels eines Plasmas, mit einer ersten Elektrode, die mit dem zu ätzenden oder zu beschichtenden Substrat in elektrischer Verbindung steht, sowie mit einer zweiten Elektrode, die oberhalb der ersten Elektrode angeordnet ist, wobei sich beide Elektroden innerhalb einer Prozeßkammer befinden, die als dritte Elektrode dient, und wobei die erste Elektrode mit einem Mittelfrequenzgenerator verbunden ist, der den Strom und die Energie des Ionenbombardements auf das Substrat steuert, während die zweite Elektrode mit einem Hochfrequenzgenerator verbunden ist, der den Betrag der Dissoziation und die Bildung der Radikale steuert, dadurch gekennzeichnet, daß der Strom des Ionenbombardements auch bei einer fest vorgegebenen Spannung des Mittelfrequenzgenerators (15) steuerbar ist.

2. Vorrichtung nach Anspruch 1, dadurch gekennzeichnet, daß bei gleichbleibender Amplitude innerhalb eines vorgegebenen Zeitraums die Spannung des Mittelfrequenzgenerators (15) intermittierend an die erste Elektrode (6) angelegt wird.

3. Vorrichtung nach Anspruch 1, dadurch gekennzeichnet, daß die Spannung impulsweise an die erste Elektrode angelegt wird, wobei die Impulse bei gleicher Amplitude und gleicher Breite verschiedene Abstände voneinander haben (Pulsphasenmodulation).

4. Vorrichtung nach Anspruch 1, dadurch gekennzeichnet, daß die Spannung impulsweise an die erste Elektrode angelegt wird, wobei die Impulse bei gleicher Amplitude verschiedene Breiten haben (Pulsbreitenmodulation).

5. Vorrichtung nach Anspruch 1, dadurch gekennzeichnet, daß die Spannung impulsweise an die erste Elektrode angelegt wird, wobei die Impulse bei gleicher Amplitude und gleicher Breite Gruppen bilden, die voneinander getrennt sind und wobei innerhalb einer Gruppe die Impulse äquidistant sind (Pulscodemodulation).

6. Vorrichtung nach Anspruch 1, dadurch gekennzeichnet, daß die Frequenz des Hochfrequenzgenerators (10) zwischen 1 MHz und 30 MHz einstellbar ist.

7. Vorrichtung nach Anspruch 1, dadurch gekennzeichnet, daß die Frequenz des Mittelfrequenzgenerators (15) zwischen 90 KHz und 450 KHz einstellbar ist.

8. Vorrichtung nach Anspruch 7, dadurch gekennzeichnet, daß ein Regler (14) vorgesehen ist, der die Amplitude der Mittelfrequenzspannung auf einen vorbestimmten Wert einstellt.

9. Vorrichtung nach einem oder nach mehreren der vorangegangenen Ansprüche, dadurch gekennzeichnet, daß die Spannungsimpulse des Mittelfrequenzgenerators (15) unipolar sind.

10. Vorrichtung nach einem oder nach mehreren der vorangegangenen Ansprüche, dadurch gekennzeichnet, daß die Impulse gleicher Amplitude durch ihre Breite oder ihren Abstand oder ihre Zahl innerhalb einer Gruppe die Amplitude der Mittelfrequenzspannung repräsentieren.

11. Vorrichtung nach Anspruch 4, dadurch gekennzeichnet, daß ein Pulsbreitenmodulator (13) vorgesehen ist, der unipolare Spannungsimpulse abgibt, deren Breite proportional zur Amplitude der vom Regler (14) kommenden Mittelfrequenzspannung ist.

12. Vorrichtung nach Anspruch 11, dadurch gekennzeichnet, daß zwischen dem Pulsbreitenmodulator (13) und der Elektrode (6), auf der sich das Substrat (7) befindet, ein Anpassungsglied (11) vorgesehen ist.

13. Vorrichtung nach Anspruch 6, dadurch gekennzeichnet, daß die Frequenz des Hochfrequenzgenerators (10) auf 13,56 MHz festgelegt ist.

14. Vorrichtung nach Anspruch 1, dadurch gekennzeichnet, daß die Impulse negative Polarität besitzen.

HF-Generator
1MHz bis 30MHz
z. B. 13.56 MHz

10

Anpassungsnetzwerk

8

9

Pulsbreitenmodulator

13

Regler für
MF-Spannungsamplitude

14

MF-Generator
90 – 450 KHz

15

Anpassungsnetzwerk

11

12

Prozeßgas

3

5

7

6

4

16

2

1

Pumpe

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 585 516  (CORN et al.)<br>* Figuren; Spalte 2, Zeile 50 - Spalte 3, Zeile 26 *<br>--- | 1,2,4, 13 | H 01 J  37/32<br>C 23 C  16/50<br>C 23 F   4/00 |
| X | EP-A-0 139 835  (TEGAL CORP.)<br>* Figur 2; Zusammenfassung *<br>--- | 1,2,13 | |
| A | US-A-4 500 563  (ELLENBERGER et al.)<br>* Zusammenfassung *<br>--- | 2-5 | |
| A,D | SOLID STATE TECHNOLOGY, Band 28, Nr. 1, Januar 1985, Seiten 150-158, Port Washington, US; S.J. FONASH: "Advances in dry etching processes -a review"<br>----- | | |
| | | | **RECHERCHIERTE SACHGEBIETE (Int. Cl.4)**<br><br>C 23 F<br>C 23 C<br>H 01 J |

Der vorliegende Recherchenbericht wurde für alle Patentansprüche erstellt

| Recherchenort | Abschlußdatum der Recherche | Prüfer |
|---|---|---|
| DEN HAAG | 04-01-1989 | PATTERSON A.M. |